# EUROPEAN PATENT APPLICATION

(11) **EP 3 499 723 A1**
(43) Date of publication of application: **19.06.2019**
(21) Application number: 18212640.9
(22) Date of filing: 14.12.2018
(51) Int. Cl.: H03K 17/567, H02M 1/12, H02M 7/06

(54) **NOISE CANCELLATION CIRCUIT, POWER SUPPLY CIRCUIT, CONTROL METHOD ACCORDING TO NOISE CANCELLATION CIRCUIT, AND PROGRAM**

(30) Priority: 18.12.2017 JP 2017241915
(71) Applicant: MITSUBISHI HEAVY INDUSTRIES THERMAL SYSTEMS, LTD., 108-8215 Tokyo (JP)
(72) Inventor: OONO, Kenzo, TOKYO, 108-8215 (JP); SUMIYA, Atsuyuki, TOKYO, 108-8215 (JP)
(74) Representative: Cabinet Beau de Loménie

(57) **Abstract**

A noise cancellation circuit provided in an anterior stage of a rectification circuit (20) is configured to cancel noise input to the rectification circuit, comprising, a plurality of coils (L1, L2), a plurality of switches (L1, L2) which are configured to switch the plurality of coils to at least one of parallel connection and serial connection, and a controller which is configured to control each of the plurality of switches to be in a short-circuit state or an open state.

## Description

### BACKGROUND OF THE INVENTION

### Field of the Invention

The present invention relates to a noise cancellation circuit, a power supply circuit, a control method according to the noise cancellation circuit, and a program.

### Description of Related Art

A power supply circuit which switches AC power to DC power is known. This power supply circuit is generally called a converter.

Patent Document 1 discloses a technology pertaining to a circuit using a coil which improves a power factor in the output of a converter.

### [Patent Documents]

[Patent Document 1] Japanese Unexamined Patent Application, First Publication No. 2002-095257

### SUMMARY OF THE INVENTION

Incidentally, a technology for canceling noise by serially disposing one coil on an input path of a converter is known. However, when a current flows through this coil, a specific point in a power supply circuit at which the coil is disposed is heated according to heat generation of the coil and thus desired characteristics may not be obtained.

Accordingly, there is a demand for a technology capable of distributing heat generating points when a coil is serially disposed on an input path of a converter to cancel noise.

An object of the present invention is to provide a noise cancellation circuit, a power supply circuit, a control method according to the noise cancellation circuit, and a program capable of solving the aforementioned problem.

According to a first aspect of the present invention, a noise cancellation circuit is provided in an anterior stage of a rectification circuit is configured to cancel noise input to the rectification circuit, and includes: a plurality of coils; a plurality of switches which are configured to switch the plurality of coils to at least one of parallel connection and serial connection; and a controller which is configured to control each of the plurality of switches to be in a short-circuit state or an open state.

According to a second aspect of the present invention, in the noise cancellation circuit in the first aspect, the plurality of switches may switch at least two of three or more coils to at least one of parallel connection and serial connection.

According to a third aspect of the present invention, in the noise cancellation circuit in the first aspect, the plurality of coils may be two coils which are a first coil including a first terminal and a second terminal and a second coil including a first terminal and a second terminal, the plurality of switches may be two switches which are a first switch including a first terminal, a second terminal and a third terminal and a second switch including a first terminal and a second terminal, the second terminal of the first switch may be connected to the first terminal of the first coil and the first terminal of the second switch, the third terminal of the first switch may be connected to the second terminal of the first coil and the first terminal of the second coil, and the second terminal of the second switch may be connected to the second terminal of the second coil, the controller may connect the first terminal of the first switch to the third terminal of the first switch and connect the first terminal of the second switch to the second terminal of the second switch when a current flowing through the plurality of coils is equal to or greater than a predetermined current, and the controller may connect the first terminal of the first switch to the second terminal of the first switch and open the first terminal of the second switch and the second terminal of the second switch when the current flowing through the plurality of coils is less than the predetermined current.

According to a fourth aspect of the present invention, a power supply circuit includes: the noise cancellation circuit according to any of the first to third aspects; and a converter which receives an AC voltage from which noise has been canceled by the noise cancellation circuit.

According to a fifth aspect of the present invention, a control method performed by a noise cancellation circuit which includes a plurality of coils and a plurality of switches which are configured to switch the plurality of coils to at least one of parallel connection and serial connection, and is provided in an anterior stage of a rectification circuit and thereby cancel noise input to the rectification circuit includes: controlling each of the plurality of switches to be in a short-circuit state or an open state.

According to a sixth aspect of the present invention, a program causes a computer for a noise cancellation circuit which includes a plurality of coils and a plurality of switches that switch the plurality of coils to at least one of parallel connection and serial connection, and which is provided in an anterior stage of a rectification circuit to cancel noise input to the rectification circuit, to execute controlling each of the plurality of switches to be in a short-circuit state or an open state.

The noise cancellation circuit according to an embodiment of the present invention can distribute heat generating points when a coil is serially disposed on an input path of a converter and thereby cancel noise.

### BRIEF DESCRIPTION OF THE DRAWINGS

Fig. 1 is a diagram showing a configuration of a power supply circuit according to an embodiment of the present invention.
Fig. 2 is a diagram showing a processing flow of the power supply circuit according to an embodiment of the present invention.
Fig. 3 is a schematic block diagram showing a configuration of a computer according to at least one embodiment.

### DETAILED DESCRIPTION OF THE INVENTION

### <Embodiment>

Hereinafter, a configuration of a power supply circuit according to an embodiment of the present invention will be described.

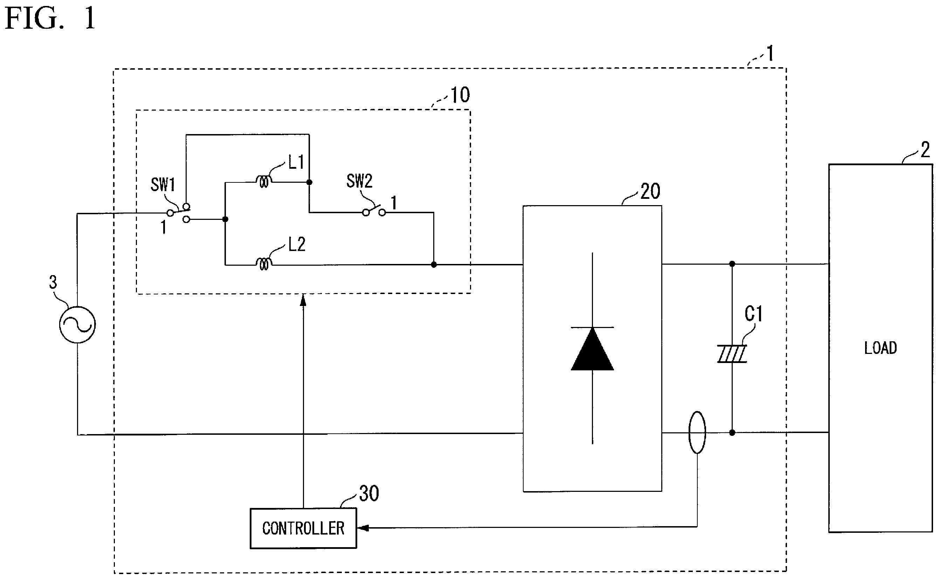

A power supply circuit 1 according to an embodiment of the present invention is a circuit which converts an AC voltage output from an AC power supply to a DC voltage and supplies the DC voltage to loads and a circuit which distributes heat generating points in a noise cancellation circuit for canceling noise of the AC power supply and alleviates heating of a specific point. As shown in Fig. 1, the power supply circuit 1 includes a noise cancellation circuit 10, a rectification circuit 20, a controller 30, and a capacitor C1. Meanwhile, the rectification circuit 20 and the capacitor C1 constitute a converter.

The noise cancellation circuit 10 receives an AC voltage output from an AC power supply 3. The noise cancellation circuit 10 filters noise in the received AC voltage to cancel the noise. The noise cancellation circuit 10 outputs the AC voltage from which the noise has been canceled to the rectification circuit 20. The noise cancellation circuit 10 includes switches SW1 and SW2 and coils L1 and L2, as shown in Fig. 1.

The switch SW1 includes a first terminal, a second terminal and a third terminal. The second switch SW2 includes a first terminal and a second terminal. Each of the coils L1 and L2 includes a first terminal and a second terminal.

The first terminal of the switch SW1 is connected to the output terminal of the AC power supply 3. The second terminal of the switch SW1 is connected to the first terminal of the coil L1 and the first terminal of the switch SW2. The third terminal of the switch SW1 is connected to the second terminal of the coil L1 and the first terminal of the coil L2. The second terminal of the switch SW2 is connected to the second terminal of the coil L2 and the input terminal of the rectification circuit 20.

The switch SW1 connects the first terminal to either of the second terminal and the third terminal on the basis of control of the controller 30.

The switch SW2 connects the first terminal to the second terminal (closed state) or opens the first terminal and the second terminal (open state) on the basis of control of the controller 30.

The coils L1 and L2 cancels noise in the AC voltage output from the AC power supply 3. Each of the coils L1 and L2 is disposed at a position that is thermally designed such that heat generated when a current flows is distributed in the power supply circuit 1.

The rectification circuit 20 receives the noise-canceled AC voltage from the noise cancellation circuit 10. The rectification circuit 20 rectifies the received AC voltage. The rectification circuit 20 charges the capacitor C1 with the rectified voltage.

The capacitor C1 is a smoothing capacitor and stabilizes the output voltage of the rectification circuit 20 to a constant voltage. The constant voltage stabilized by the capacitor C1 is supplied to a load 2.

The controller 30 controls connection in the switches SW1 and SW2 such that the coils L1 and L2 are connected in parallel when a current flowing through the load 2 is large. Specifically, when a return current from the load 2 is large, for example, the controller 30 connects the first terminal to the third terminal in the switch SW1 and connects the first terminal to the second terminal in the switch SW2. Meanwhile, a case in which a current flowing through the load 2 is large is a case in which a current flowing through the load 2 is equal to or greater than a current value that is predetermined in order to determine that heat generation in the noise cancellation circuit 10 increases. The current flowing through the load 2 is a current which passes through the noise cancellation circuit 10 from the AC power supply 3 and is supplied from the power supply circuit 1 to the load 2. Accordingly, when the current flowing through the load 2 increases, the current flowing through the noise cancellation circuit 10 also increases.

In addition, when the current flowing through the load 2 is small, the controller 30 controls connection in each of the switches SW1 and SW2 such that the coils L1 and L2 are connected in series. Specifically, for example, when the return current from the load 2 is small, the controller 30 connects the first terminal to the second terminal in the switch SW1 and opens the first terminal and the second terminal in the switch SW2. Meanwhile, a case in which the current flowing through the load 2 is small is a case in which the current flowing through the load 2 is less than the current value that is predetermined in order to determine that heat generation in the noise cancellation circuit 10 increases.

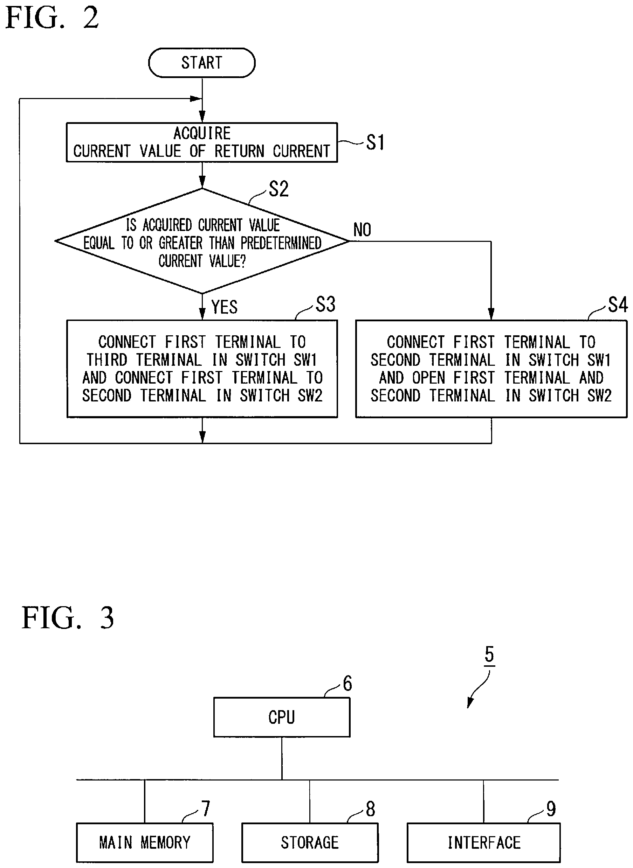

Next, processing of the power supply circuit 1 according to an embodiment of the present invention will be described using Fig. 2. When the power supply circuit 1 starts and the AC voltage is supplied from the AC power supply 3 to the power supply circuit 1, a current flows through the load 2. The current flowing through the load 2 is returned to the AC power supply 3 as a return current.

The controller 30 acquires a current value of the return current from a current sensor provided on a return current path (step S1). The controller 30 determines whether or not the acquired current value is equal to or greater than a current value predetermined in order to determine that heat generation in the noise cancellation circuit 10 increases (step S2).

When it is determined that the acquired current value is equal to or greater than the predetermined current value (YES in step S2), the controller 30 connects the first terminal to the third terminal in the switch SW1 and connects the first terminal to the second terminal in the switch SW2 (step S3).

In addition, when it is determined that the acquired current value is less than the predetermined current value (NO in step S2), the controller 30 connects the first terminal to the second terminal in the switch SW1 and opens the first terminal and the second terminal in the switch SW2 (step S4).

The power supply circuit 1 according to an embodiment of the present invention has been described above. In the power supply circuit 1, the noise cancellation circuit 10 includes the two coils L1 and L2, the two switches SW1 and SW2 which can connect the two coils L1 and L2 at least one of in parallel and in series according to combinations of a short-circuit state and an open state, and the controller 30 which controls each of the two switches SW1 and SW2 to be in the short-circuit state or the open state. The controller 30 connects the first terminal of the switch SW1 to the third terminal thereof and connects the first terminal of the switch SW2 to the second terminal thereof when a current flowing through the two coils L1 and L2 is equal to or greater than a predetermined current. In addition, the controller 30 connects the first terminal of the switch SW1 to the second terminal thereof and opens the first terminal of the switch SW2 and the second terminal thereof when a current flowing through the two coils L1 and L2 is less than the predetermined current.

Accordingly, when the current flowing through the two coils L1 and L2 is large, the current can be branched to each of the coils L1 and L2 and thus the current flowing through each of the coils L1 and L2 can be reduced. Each of the coils L1 and L2 is disposed at each of positions set according to thermal design.

Consequently, it is possible to distribute heat generating points when a coil is serially disposed on an input path of a converter to cancel noise.

Further, when the current flowing through the two coils L1 and L2 is small, it is possible to improve the noise cancellation effect by connecting the coils L1 and L2 in series because little heat is generated.

Meanwhile, in another embodiment of the present invention, switches which switch at least two of a plurality of coils to at least one of parallel connection and serial connection may be provided, and when a current flowing through the coils is large, the current may be distributed to flow through the two or more coils connected in parallel.

Meanwhile, in another embodiment of the present invention, switches which switch at least two of three or more coils to at least one of parallel connection and serial connection may be provided, and when a current flowing through the coils is large, the current may be distributed to flow through the two or more coils connected in parallel.

Further, a processing order in embodiments of the present invention may be changed within a range in which appropriate processing is performed.

Each storage unit may be included in any place within a range in which appropriate information transmission and reception are performed. In addition, a plurality of storage units may be present within a range in which appropriate information transmission and reception are performed and store data in a distributed manner.

Although embodiments of the present invention have been described, the aforementioned controller 30 and other control devices may include a computer system therein. In addition, the above-described processing procedure may be stored in a computer readable recording medium in the form of a program, and the aforementioned process may be performed by a computer reading and executing the program. A specific example of the computer will be described below.

Fig. 3 is a schematic block diagram showing a configuration of a computer according to at least one embodiment.

As shown in Fig. 3, a computer 5 includes a CPU 6, a main memory 7, a storage 8 and an interface 9.

For example, each of the aforementioned controller 30 and other control devices is mounted in the computer 5. In addition, the operation of each of the aforementioned processing units is stored in the storage 8 in the form of a program. The CPU 6 reads a program from the storage 8, loads the program in the main memory 7 and executes the aforementioned process in accordance with the program. Further, the CPU 6 secures a storage region corresponding to each of the above-described storage units in the main memory 7 according to the program.

As examples of the storage 8, a hard disk drive (HDD), a solid state drive (SSD), a magnetic disk, a magneto-optical disc, a compact disc read only memory (CD-ROM), a digital versatile disc read only memory (DVD-ROM), a semiconductor memory and the like are conceivable. The storage 8 may be internal media directly connected to a bus of the computer 5 or may be external media connected to the computer 5 through the interface 9 or a communication line. In addition, when the program is delivered to the computer 5 through a communication line, the computer 5 which has received delivery may load the program in the main memory 7 and execute the above-described process. In at least one embodiment, the storage 8 is a non-transitory physical storage medium.

Furthermore, the aforementioned program may realize some of the above-described functions. Further, the program may be a file known as a differential file (differential program) which can realize the above-described functions according to a combination with a program which has already been recorded in a computer system.

Although some embodiments of the present invention have been described, such embodiments are examples and do not limit the scope of the present invention. Such embodiments may be embodied in various other forms and omissions, substitutions and modifications can be made in various manners without departing from the scope of the present invention.

### EXPLANATION OF REFERENCES

1 Power supply circuit
2 Load
3 AC power supply
10 Noise cancellation circuit
20 Rectification circuit
30 Controller
C1 Capacitor
SW1, SW2 Switch
L1, L2 Coil

## Claims

1. A noise cancellation circuit provided in an anterior stage of a rectification circuit (20) is configured to cancel noise input to the rectification circuit, comprising:
a plurality of coils (L1, L2);
a plurality of switches (SW1, SW2) which are configured to switch the plurality of coils to at least one of parallel connection and serial connection; and
a controller (30) which is configured to control each of the plurality of switches to be in a short-circuit state or an open state.

2. The noise cancellation circuit according to claim 1,
wherein the plurality of switches switch at least two of three or more coils to at least one of parallel connection and serial connection.

3. The noise cancellation circuit according to claim 1,
wherein the plurality of coils are two coils which are a first coil including a first terminal and a second terminal and a second coil including a first terminal and a second terminal,
the plurality of switches are two switches which are a first switch including a first terminal, a second terminal and a third terminal and a second switch including a first terminal and a second terminal,
the second terminal of the first switch is connected to the first terminal of the first coil and the first terminal of the second switch, the third terminal of the first switch is connected to the second terminal of the first coil and the first terminal of the second coil, and the second terminal of the second switch is connected to the second terminal of the second coil,
the controller connects the first terminal of the first switch to the third terminal of the first switch and connects the first terminal of the second switch to the second terminal of the second switch when a current flowing through the plurality of coils is equal to or greater than a predetermined current, and
the controller connects the first terminal of the first switch to the second terminal of the first switch and opens the first terminal of the second switch and the second terminal of the second switch when the current flowing through the plurality of coils is less than the predetermined current.

4. A power supply circuit comprising:
the noise cancellation circuit (10) according to any of claims 1 to 3; and
a converter which receives an AC voltage from which noise has been canceled by the noise cancellation circuit.

5. A control method performed by a noise cancellation circuit which includes a plurality of coils (L1, L2) and a plurality of switches (SW1, SW2) which are configured to switch the plurality of coils to at least one of parallel connection and serial connection, and is provided in an anterior stage of a rectification circuit (20) and thereby cancel noise input to the rectification circuit, the control method comprising:
controlling each of the plurality of switches to be in a short-circuit state or an open state.

6. A program causing a computer for a noise cancellation circuit which includes a plurality of coils (L1, L2) and a plurality of switches (SW1, SW2) that switch the plurality of coils to at least one of parallel connection and serial connection, and which is provided in an anterior stage of a rectification circuit (20) to cancel noise input to the rectification circuit, to execute:
controlling each of the plurality of switches to be in a short-circuit state or an open state.
